(19) Europäisches Patentamt

European Patent Office

Office européen des brevets

(11) Veröffentlichungsnummer: **0 270 069 B1**

# (12) EUROPÄISCHE PATENTSCHRIFT

(45) Veröffentlichungstag der Patentschrift: **03.06.92**

(51) Int. Cl.⁵: **H01L 25/04**, H01L 23/367,
H01L 23/31, H01L 23/482

(21) Anmeldenummer: **87117739.0**

(22) Anmeldetag: **01.12.87**

(54) **Modul mit Halbleiter-Leistungsschaltelementen.**

(30) Priorität: **02.12.86 US 936797**

(43) Veröffentlichungstag der Anmeldung:
**08.06.88 Patentblatt 88/23**

(45) Bekanntmachung des Hinweises auf die
Patenterteilung:
**03.06.92 Patentblatt 92/23**

(84) Benannte Vertragsstaaten:
**CH DE ES FR GB IT LI NL SE**

(56) Entgegenhaltungen:
**US-A- 3 839 660**

**PATENT ABSTRACTS OF JAPAN, Band 7, Nr.
129 (E-179) (1274), 4. Juni 1983; & JP-A-58
43544**

(73) Patentinhaber: **Anton Piller GmbH & Co. KG
Abgunst 24
W-3360 Osterode/Harz(DE)**

(72) Erfinder: **Sachs, Klaus, Dipl.-Ing.
Ouellenweg 26
W-3360 Osterode/Harz(DE)**

(74) Vertreter: **Becker, Thomas, Dr. et al
Becker & Müller Patentanwälte Eisenhüttenstrasse 2
W-4030 Ratingen 1(DE)**

EP 0 270 069 B1

**Beschreibung**

Die Erfindung bezieht sich auf ein Modul mit Halbleiter-Leistungsschaltelementen.

Zur Erzielung einer hohen Leistung ist es bekannt, eine Mehrzahl von Halbleiter-Leistungsschaltelementen, auch solche unterschiedlicher Art, auf einer Keramik-Substratplatte anzuordnen. Die Substratplatte ist dabei auf ihrer Oberfläche mit Leiterbahnen versehen, auf denen die die Schaltelemente bildenden Chips mit einer Anschlußfläche elektrisch kontaktierend befestigt sind. Die Leiterbahnen sind dabei mit Anschlußfahnen oder -beinen verbunden, wobei diese Verbindungen über Bonddrähte erfolgen können. Es ist auch bekannt, die Anschlußfahnen direkt mit den Leiterbahnen zu verbinden. Module der genannten Art werden ausgelegt für Leistungen im Bereich bis einige -zig KW bei Betriebsspannungen bis 500 V und Strömen bis 100 A. Derartige Module haben Verlustleistungen, die nur über besondere Kühlelemente abgeführt werden können. Es ist daher bekannt, die Substratplatte auf einer Wärmesenke elektrisch leitend zu befestigen, beispielsweise über eine auf der Substratplatte angeordnete Metallschicht mit der Wärmesenke zu verlöten. Die Wärmesenke ist dabei vielfach eine Metallplatte, mit der das Modul auf bzw. an einem entsprechend dimensionierten Kühlkörper durch Schrauben befestigt wird (DE-A 28 19 327, DE-A 32 11 975, DE-U 82 14 214).

Bei Modulen ist es weiter bekannt, diese zum Schutz der Chips und der Anschluß zu vergießen. Zu diesem Zweck ist es bekannt, die Substratplatten in den Boden eines vorgefertigten Gehäuses einzusetzen und das Gehäuse dann anschließend mit einer Vergußmasse auszugießen. Das Gehäuse kann dabei gleichzeitig mit Befestigungsmitteln versehen sein, mit denen das Modul mit der Substratplatte direkt an einem Kühlelement anliegend auf diesem befestigbar ist (DE-A 30 28 178, DE-A 32 41 508, US-A 38 39 660).

Bei Modulen mit Halbleiter-Leistungsschaltelementen ist es darüber hinaus bekannt, die die Chips tragende Substratplatte als Boden in ein Gehäuse einzusetzen, in dem gegenüberliegend eine weitere Substratplatte mit Steuerelementen angeordnet ist und beide Substratplatten durch Schrauben oder dergleichen in dem Gehäuse zu haltern (US-A 4 218 724).

Ein Problem beim Vergießen von Modulen mit Halbleiter-Leistungsschaltelementen, die eine Vielzahl von Chips auf einer Substratplatte tragen und bei der denen die Substratplatte daher entsprechend große Abmessungen haben kann, die beispielsweise in der Größenordnung 25 x 35 mm bis hin zu 50 x 50 mm haben kann, liegt in den erheblichen Unterschieden im Wärmedehnungskoeffizienten der Substratplatte mit 4 bis 6 x $10^{-6}$-

$(K^{-1})$ und den üblicherweise für das Vergießen von Halbleiterbauelementen verwendeten Kunststoffes in der Größenordnung von 18 x $10^{-6}(K^{-1})$. Die Schwierigkeiten liegen hier einmal bei der unterschiedlichen Kontraktion von Substrat und Kunststoff beim Abkühlen nach dem Spritzgießen. Bei großen Chipflächen führt dies unvermeidlich zu Verbiegungen der Substratplatte, die bei der erwähnten Befestigung auf einer Wärmesenke bzw. einem Kühlkörper nur noch eine linien- bis punktförmige Berührung ermöglicht, die keine ausreichende Abführung der im Betrieb auftretenden Verlustwärme ermöglicht.

Es ist bekannt, dies dadurch zu vermeiden, daß die Substratplatte vor dem Vergießen mit einer Metallplatte entsprechend großer Biegesteifigkeit verbunden wird und diese Platte dann mit umspritzt wird, wobei die Haftung des Gehäuses durch eine schwalbenschwanzförmige Ausbildung des Randes der Metallplatte sichergestellt wird (US-A 3 839 660).

Bei Halbleiterbauelementen geringer Leistung wird die Substratplatte mit den Chips, die dabei ein- oder beidseitig auf der Substratplatte angeordnet sein können, normalerweise in die Mittelebene des Vergußkörpers gelegt (JP-A 58-130 553, englischer Abstract). Aber auch hierbei kann es zu erheblichen Spannungen kommen. So ist es bekannt, zur Vermeidung von Verwerfungen einen Halbleiterchip über eine Lötschicht mit einem Metallkörper als Leiterbahn zu verbinden, bei der die Wärmeausdehnungskoeffizienten des Chips, der Lötschicht und der Leiterbahn so aufeinander abgestimmt sind, daß beim Umspritzen keine wesentlichen Verwerfungen auftreten. Dabei ist auch hier die Leiterbahn und der Chip in der Mittelebene des Vergußkörpers angeordnet (US-A 4 604 642).

Aufgabe der Erfindung ist es, ein Modul mit Halbleiterschaltelementen für große Leistungen zu schaffen, bei dem die Schaltelemente in einem durch ein Spritzgießverfahren erzeugten Kunststoffkörper eingeschlossen sind und bei dem keine Verwerfungen der Substratplatte auftreten.

Diese Aufgabe wird gemäß der Erfindung gelöst durch die im Patentanspruch 1 herausgestellten Merkmale.

Zweckmäßig Ausführungsformen sind Gegenstand der abhängigen Ansprüche 2 und 3.

Ein Modul gemäß der Erfindung hat zwei gegenüberliegende parallele Flächen, nämlich die Außenflächen der Substratplatten, gegebenenfalls mit einer Metallbeschichtung, mit denen das Modul beidseitig mit einem Kühlkörper in wärmeleitende Berührung gebracht werden kann. So kann beispielsweise ein oder eine Mehrzahl von Modulen gemäß der Erfindung nebeneinander zwischen zwei Kühlkörpern eingespannt werden, wodurch eine sehr hohe Leistungsdichte erreichbar ist.

Die erfindungsgemäße Ausbildung des Moduls hat darüber hinaus den Vorteil, daß ein sauberer Ausgleich der Spannungen innerhalb des Moduls erreicht wird in den Ausbildungen, bei denen auf beiden Substratplatten Halbleiter-Leistungsschaltelemente angeordnet sind.

Die Erfindung ist in der Zeichnung beispielsweise veranschaulicht und im nachstehenden im einzelnen anhand der Zeichnung beschrieben.

Fig. 1  zeigt in schematischer Darstellung in Draufsicht eine Substratplatte mit einer Mehrzahl von Halbleiter-Leistungsschaltelementen, wie sie in einem Modul gemäß der Erfindung Anwendung finden kann.

Fig. 2  zeigt in Draufsicht einen Rahmen mit daran angeordneten Anschlußfahnen, wie er bei der Herstellung eines Moduls gemäß der Erfindung Verwendung findet.

Fig. 3  zeigt die Verbindung des Rahmens nach Fig. 2 mit einer Substratplatte nach Fig. 1 sowie deren Bestückung mit Halbleiterelementen und Verdrahtung mittels Bonddrähten.

Fig. 4  zeigt einen Schnitt längs der Linie IV-IV in Fig. 3 und gibt den Rahmen nach Fig. 2 verbunden mit den Leiterbahnen der Substratplatte nach Fig. 1 wieder.

Fig. 5  ist ein Schnitt, ähnlich Fig. 4, bei der jedoch die Substratplatte auf ihrer den Leiterbahnen gegenüberliegenden äußeren Oberfläche mit einer Beschichtung aus einem wärmeleitenden Material versehen ist.

Fig. 6  zeigt zwei Rahmen nach Fig. 3 und 4 übereinander angeordnet in Vorbereitung für das Vergießen.

Fig. 7  zeigt das vergossene fertige Modul in perspektivischer Darstellung.

Fig. 8  zeigt einen Schnitt längs der Linie VIII-VIII in Fig. 7.

Fig. 9  zeigt in einem Schnitt, ähnlich Fig. 6, die Anordnung mit Substratplatten, die auf ihrer Außenseite mit einer wärmeleitenden Metallschicht versehen sind.

Fig. 10  zeigt das vergossene Modul mit wärmeleitenden äußeren Oberflächen der Substratplatten.

Fig. 11  zeigt einen Schnitt längs der Linie XI-XI in Fig. 10.

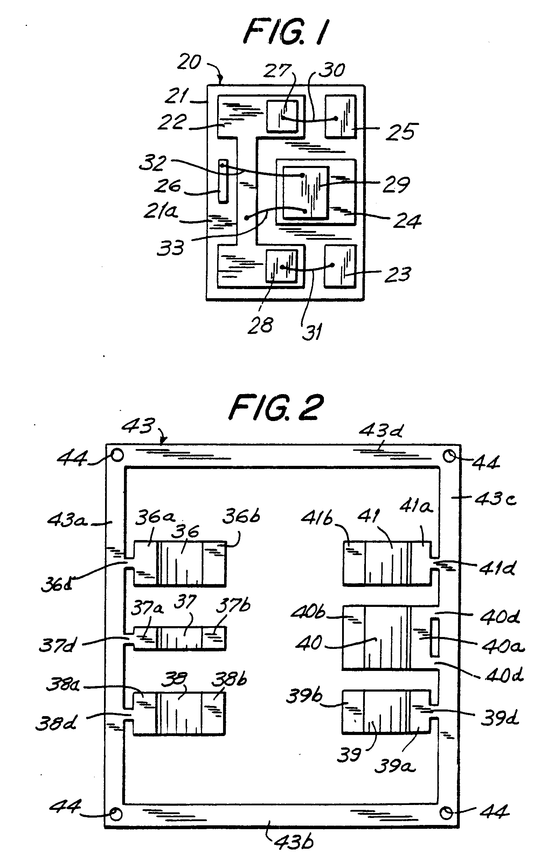

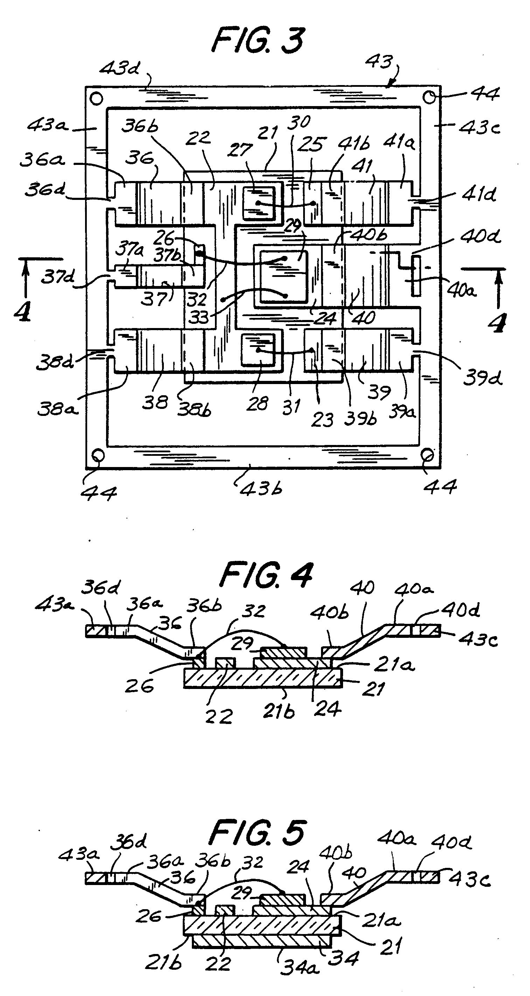

In Fig. 1 ist schematisch ein Element 20 eines Schaltkreises mit Halbleiter-Leistungsschaltelementen dargestellt, wie es in einem Modul gemäß der Erfindung Anwendung findet. Das Element 20 weist eine Substratplatte 21 auf, die aus einem konventionellen elektrisch nicht leitenden Material besteht, beispielsweise Aluminiumoxid ($Al_2O_3$) oder Aluminiumnitrit (AlN). Die Substratplatte 21, die in Rechteckform dargestellt ist, aber auch jede andere Konfiguration haben kann, hat zwei gegenüberliegende ebene Oberflächen 21a und 21b, wie aus Fig. 4 und 5 ersichtlich ist. Auf die Oberfläche 21a ist in üblicher Art eine Vielzahl diskreter flächiger Leiterschichten, -inseln oder -bahnen 22, 23, 24, 25 und 26 - im nachstehenden Leiterbahnen genannt - angeordnet, die vorzugsweise aus Kupfer bestehen. Im allgemeinen sind Substratplatten, die übrigens auch aus anderen geeigneten Materialien bestehen können, jeweils etwa 0,6 bis 1 mm dick, während die Leiterbahnen jeweils 0,1 mm bis 0,3 mm dick sind, wie in der Technik bekannt. Die Zahl, Verteilung und Ausbildung der einzelnen Leiterbahnen 22 bis 26 kann selbstverständlich von der in Fig. 1 dargestellten abweichen, je nachdem, für welche Verwendung das Modul 20 bestimmt ist.

Auf den Leiterbahnen sind Halbleiter-Bauelemente 27, 28 und 29, wie beispielsweise Transistoren, Dioden, Thyristoren SCR, MOS-Schaltkreise, integrierte Schaltkreise unterschiedlichster Art und dergleichen befestigt, die im nachstehenden auch kurz als Siliciumchips bezeichnet werden. Die Ausbildung und Anzahl der Siliciumchips richtet sich nach der Anwendung und der angestrebten Leistung. In der dargestellten Ausführungsform sind die Siliciumchips 27, 28 und 29 jeweils mit einem Anschluß elektrisch mit der darunter liegenden Leiterbahn verbunden und ein oder mehrere weitere Anschlüsse sind elektrisch über Bonddrähte 30, 31, 32 und 33 miteinander bzw. mit einer oder mehreren unterschiedlichen Leiterbahnen oder Anschlußfahnen verbunden.

Die andere flache Oberfläche 21b der Substratplatte kann entweder unbeschichtet sein, wie in Fig. 4 dargestellt, oder sie kann, wie in Fig. 5 dargestellt, mit einer dünnen Schicht 34 aus einem thermisch hoch leitenden Material, beispielsweise Kupfer, versehen sein, wobei die Schicht sich vorzugsweise im wesentlichen über die gesamte Fläche 21b erstreckt. Während bei der Ausführungsform nach Fig. 4 die Substratplatte mit ihrer Außenseite, die der die Siliziumchips tragenden Seite gegenüberliegt, direkt in Eingriff mit einem Kühlkörper als Wärmesenke gebracht wird, erfolgt bei der Ausführungsform nach Fig. 5 die Berührung mit der Wärmesenke über die thermisch hochleitende Schicht, die beispielsweise eine Dicke von einigen 10tel Millimeter haben kann. Die Dicken sind in den Zeichnungen zum Zwecke der Klarheit übertrieben dargestellt.

Um die Siliciumchips und deren Verbindungen und Anschlüsse zu schützen, ist das Modul in ein Gehäuse 42 aus einem spritzgießbaren wärmehärtenden Kunstharz mit entsprechenden elektrischen Eigenschaften eingeschlossen. Der thermische Längenausdehnungskoeffizient $\alpha$ der hier in Frage kommenden Kunststoffe oder Kunststoffverbindungen mit etwa $18 \times 10^{-6}(K^{-1})$ oder mehr im allgemeinen drei- bis viermal größer als der thermische Längenausdehnungskoeffizient $\alpha$ der Substratplatte, der bei etwa $4$ bis $6 \times 10^{-6}(K^{-1})$ liegt. Bei der normalen Spritzgießtemperatur von beispielsweise 170 bis 180 °C wird sich die Substratplatte, insbesondere, wenn sie relativ groß ist, beispielsweise 40 x 40 bis etwa 100 x 100 cm, bei einem einseitig angespritzten Gehäuse aufgrund der unterschiedlichen thermischen Längenausdehnungskoeffizienten des eingespritzten Kunststoffes und der Substratplatte bei der Abkühlung verwerfen. Ein solches Verwerfen führt dazu, daß der wirksame Kontakt zwischen der außen liegenden Oberfläche 34, 34a der Substratplatte 21 und einer Wärmesenke auf eine linienförmige oder sogar punktförmige Berührung reduziert wird anstatt der gewünschten und notwendigen vollflächigen Berührung. Auf der anderen Seite kann es auch aufgrund der durch die unterschiedliche thermische Längenausdehnungskoeffizienten erzeugten Spannungen zu einem Lösen der Verbindungen der Siliciumchips mit den Leiterbahnen kommen. Auf alle Fälle beeinträchtigt ein Verwerfen der Substratplatte den Wärmefluß von dem Modul zur Wärmesenke. Damit wird die notwendige Ableitung der Verlustwärme beeinträchtigt, so daß es schließlich dazu kommen kann, daß die Siliciumchips des Moduls durch Überhitzung geschädigt werden.

Gemäß der Erfindung werden diese Nachteile dadurch vermieden, daß die in Fig. 5 dargestellte Anordnung von zwei Elementen 20 gewählt wird, bei der die beiden Substratplatten 21 auf ihren einander zugewandten Oberflächen die Leiterbahnen und die Siliciumchips tragen. Die Ausbildung und Bestückung der Substratplatten sollte dabei spiegelbildlich zueinander sein, damit die erwünschte Deckungsgleichheit der Anschlußfahnen erzielt wird, über die die äußeren Anschlüsse hergestellt werden.

Die beiden Elemente 20 sind mit steifen, elektrisch leitenden Anschlußfahnen 36, 37, 38, 39, 40 und 41, die vorzugsweise aus Kupfer bestehen, versehen, die im einzelnen in Fig. 3 dargestellt sind. Diese Anschlußfahnen liegen mit ihren äußeren Endbereichen 36a bis 41a im wesentlichen in der Mittelebene des fertigen Moduls, während die inneren Endbereiche 36b bis 41b, die gegenüber der Mittelebene in der Höhe versetzt, aber vorzugsweise zu ihr parallel liegen, elektrisch mit den jeweiligen ebenen Leiterbahnen 22 bis 26 auf den Substratplatten 21 verbunden sind. Die einzelnen Anschlußfahnen sind mit ihren Endbereichen über schmale Zungen 36d bis 41d mit einem Rahmen 43 verbunden, wobei die Anschlußfahne mit zwei solchen Zungen dargestellt ist, was jedoch nicht von wesentlicher Bedeutung ist. Die Rahmen 43 sind Fertigungshilfen, wie weiter unten noch zu erläutern sein wird.

Die beiden Elemente 20 des Moduls 35, 35′, die hier zwei identische symmetrisch ausgebildete Elemente mit einer Mehrzahl von Siliciumchips sind, liegen einander spiegelbildlich gegenüber, so daß die entsprechenden äußeren Endbereiche der Leiterfahnen mit identischen Anschlüssen an Siliciumchips jeweils spiegelbildlich gegenüberliegen und in der Mittelebene somit elektrisch verbindbar sind. Soweit eine derartige Parallelschaltung nicht möglich ist, sind die entsprechenden Anschlußfahnen gegeneinander versetzt anzuordnen. Abhängig von dem beabsichtigten Zweck des Moduls können die beiden Elemente voneinander hinsichtlich der Typen, der Strukturen und der Anordnungen ihrer entsprechenden elektrischen Komponenten abweichen. Anschlußfahnen können statt von zwei gegenüberliegenden Seiten, wie dargestellt, auch von drei oder auch von allen vier Seiten vorstehen. Es ist weiter nicht zwingend, daß das Modul in Draufsicht viereckig ist. Die dargestellte Ausführung mit Anschlußfahnen an zwei gegenüberliegenden Seiten hat den Vorteil, daß eine Mehrzahl von Modulen in einer Reihe zwischen zwei Kühlkörpern ohne Zwischenraum zwischen den Modulen eingespannt werden kann.

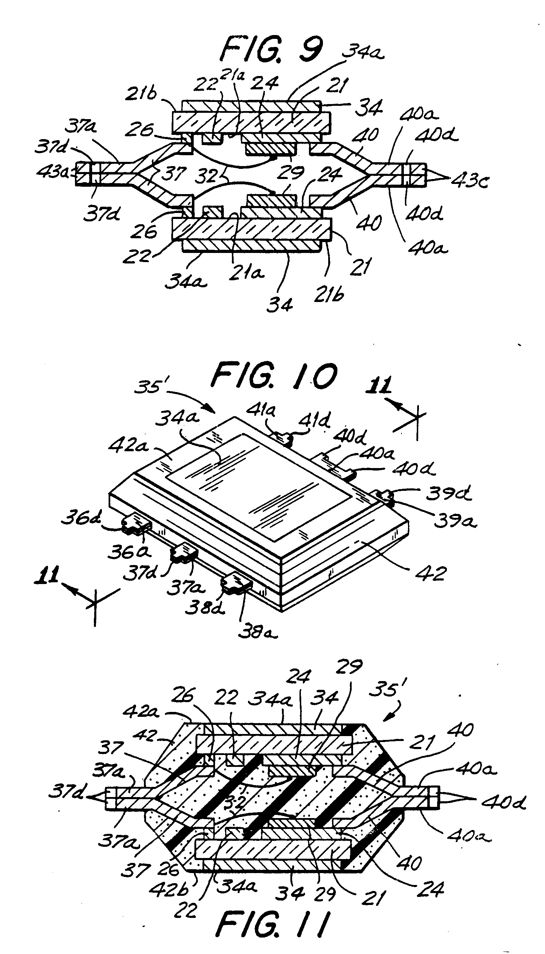

Die Elemente 20 und die Anschlußfahnen sind in einem Gehäuse 42 eingeschlossen, das aus einer wärmehärtenden Spritzgießmasse besteht, die den Anforderungen an die elektrischen Isoliereigenschaften für Halbleiteranordnungen entspricht. Dies kann beispielsweise eine wärmehärtende Spritzgußmasse auf der Basis von Epoxid sein, wie sie beispielsweise unter der Produktbezeichnung MG 36 F der Hysol Divison der The Dexter Corporation geliefert wird. Die Spritzgießmasse schließt alle Siliciumchips zwischen den beiden Substratplatten ein. Sie erstreckt sich vorzugsweise auch über den Umfang der Substratplatten. In einer zweckmäßigen Ausführungsform liegen die einander gegenüberliegenden Oberflächen 42a und 42b des durch Spritzgießen hergestellten Gehäuses 42 in einer Ebene mit den äußeren freiliegenden Oberflächen 21b der beiden Substratplatten 21 bzw., wie in Fig. 11 dargestellt, in der Ebene der äußeren Oberflächen 34a der auf den Substratplatten 21 aufgebrachten Schichten 34a aus hochwärmeleitendem Material.

Die Fertigung der oben beschriebenen Module kann wie folgt durchgeführt werden.

Auf die Substratplatten werden die Leiterbahnen in entsprechender Konfiguration ausgebildet. Dies kann beispielsweise in üblicher Weise durch Abätzen einer auf der Substratplatte ausgebildeten Kupferschicht geschehen. Auf der anderen Seite wird aus Kupferblech mit einer Dicke von 0,4 bis 1 mm der in Fig. 2 dargestellte Rahmen 43 hergestellt, beispielsweise durch Stanzen oder gleichfalls durch Ätzen. Hierbei sind an die Schenkel 43a bzw. 43c die Leiterfahnen 36 bis 38 bzw. 39 bis 41 über die Zungen 36d bis 38d bzw. 39d bis 41d verbunden. An die beiden übrigen sich gegenüberliegenden Schenkel 43b und 43d sind keine Leiterfahnen angeschlossen. In den Ecken des Rahmens 43 sind Paßlöcher 44 vorgesehen. Der Rahmen mit den daran anhängenden Leiterfahnen wird so verformt, daß die innen liegenden Endbereiche 36b bis 41b der Leiterfahnen in der Höhe gegenüber den in der Ebene des Rahmens 43 verbleibenden Endbereichen 36a bis 41a der Anschlußfahnen 36 bis 41 liegen.

Die so vorgeformten Rahmen werden mit den innenliegenden Endbereichen der Anschlußfahne mit den entsprechenden Leiterbahnen der Substratplatte 21 elektrisch leitend verbunden. Anschließend kann die Substratplatte mit den Siliciumchips in bekannter Weise bestückt werden und es können dann die Bonddrähte hergestellt werden. Der Höhenversatz zwischen der Ebene des Rahmens 43 und den inneren Endbereichen 36b bis 41b der Anschlußfahnen ist so gewählt, daß die Siliciumchips bzw. die Bonddrähte nicht über die Ebene des Rahmens 43 vorstehen.

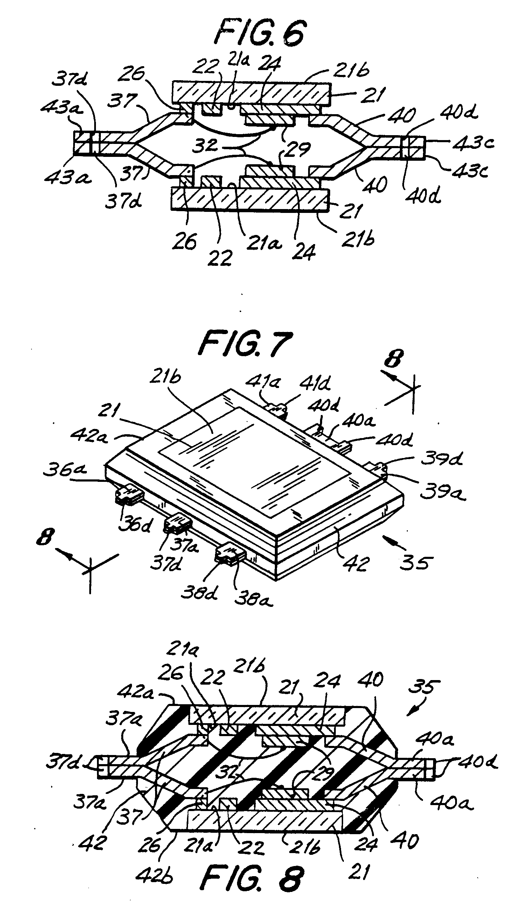

Die so vorbereiteten Hälften des Moduls, die in Fig. 3 in Draufsicht und in Fig. 4 bzw. 5 im Querschnitt dargestellt sind, werden dann in der in Fig. 6 bzw. 9 dargestellten Weise mit den Rahmen aufeinanderliegend zusammengefügt. Die beiden Hälften können dann durch Verbindungen im Rahmen, beispielsweise durch Punktschweißungen oder Lötungen, gegeneinander fixiert werden.

Die so vorbereitete Grundeinheit des Moduls wird dann in eine Spritzgießform eingesetzt, wobei mit Hilfe der Paßlöcher eine Fixierung innerhalb der Form erfolgt. Die Abmessungen der Form sind so zu wählen, daß die Substratplatte mit ihrer äußeren Oberfläche 21b bzw. mit der äußeren Oberfläche 34a der wärmeleitenden Beschichtung an gegenüberliegenden Flächen des Formhohlraums anliegen. Durch Wahl des Höhenversatzes der Anschlußfahnen kann hierbei eine gewisse Vorspannung erzielt werden. Die Form ist weiter so auszugestalten, daß die außen liegenden Endbereiche 36a bis 41a der Anschlußfahnen außerhalb des Formhohlraumes liegen.

Nach Schließen der Form wird in den Formhohlraum eine wärmehärtende Spritzgießmasse, vorzugsweise auf der Basis von Epoxidharz, eingespritzt. Verwendet werden kann, wie bereits erwähnt, beispielsweise die oben erwähnte Hysol-Spritzgießmasse MG 36 F. Die Spritzgießmasse wird bei einer Temperaturen zwischen 170 bis 180 °C injiziert bei einem Druck von 4 bis 8 MPa. Die Aushärtedauer für die Spritzgießmasse beträgt etwa 120 bis 180 sec. Die aus der Form entnommenen Module sind anschließend noch für eine Zeitdauer von etwa 6 Stunden bei etwa 175 °C zu tempern.

Beim Abkühlen des Moduls nach Entnahme aus der Form bzw. nach Entnahme aus dem Temperofen werden die Module auf Raumtemperatur abgekühlt. Es wurde dabei festgestellt, daß trotz des Unterschiedes hinsichtlich des thermischen Längenausdehnungskoeffizienten in der Größenordnung von 1 zu 4 die äußeren Oberflächen der Substratplatten keine Verwerfungen bei der Abkühlung erleiden. Damit sind optimale Wärmeübertragungsbedingungen durch im wesentlichen vollflächige Anlage an einer Wärmesenke garantiert. Es besteht weiter keine Gefahr, daß sich die Siliciumchips von ihren Leiterbahnen lösen oder daß Bonddrähte reißen.

Das spritzgegossene Gehäuse hat eine Wärmeleitfähigkeit von $18 \times 10^{-4}$ und einen Volumenwiderstand (bei 500 V und 25 °C) von $3,0 \times 10^{16}$ Ohm-cm. Die Module haben damit ausgezeichnete thermische und elektrische Eigenschaften.

Nach dem Abkühlen der Module auf Raumtemperatur werden die die Anschlußfahnen verbindenden Rahmen 43 entfernt, beispielsweise durch Stanzen.

Im vorstehenden ist die Erfindung beschrieben in Verbindung mit zwei einander gegenüberliegenden Substratplatten, die jeweils mit Siliciumchips bestückt sind. Dies ist nicht zwingend. Es kann vielmehr auch eine der Substratplatten ohne Bestückung mit Siliciumchips, also ohne elektrische Wirksamkeit verwendet werden. Auch in einem solchen Fall sind zweckmäßig für diese "leere" Substratplatte Anschlußfahnen wie im vorstehenden beschrieben oder entsprechende Äquivalente vorzusehen, mit denen die "leere" Substratplatte in der Spritzgießform gehalten wird. Auch bei einer solchen Ausführungsform sichert die zweite Substratplatte das Modul gegen Verwerfungen und schafft gleichzeitig eine zweite Anlagefläche für eine Wärmesenke zum Abführen der innerhalb des Moduls entstehenden Verlustwärme.

**Patentansprüche**

1. Modul mit Halbleiter-Leistungsschaltelementen (27,28,29), bei dem zwei Substratplatten (21) aus einem elektrisch isolierenden Werkstoff parallel zueinander im Abstand voneinander angeordnet sind, die auf ihren einander zugewandten Oberflächen (21a) mit Leiterbahnen (22-26) versehen sind, auf denen wenigstens bei einer der Substratplatten (21) die Halbleiter-Leitungsschaltelemente (27,28,29) mit einer Anschlußfläche elektrisch kontaktierend befestigt sind, bei dem weiter die Leiterbahnen (22-26) mit Anschlußfahnen (36-41) verbunden sind, die wenigstens über zwei gegenüberliegende Ränder der Substratplatte (21) überstehen, bei dem die Anschlußfahnen (36-41) mit ihren außenliegenden Anschlußenden (36a-41a) in der Mittelebene zwischen den Substratplatten (21) liegen, und bei dem das Modul mit einer Spritzgießmasse so vergossen ist, daß die Außenflächen (21b) der Substratplatten (21) frei liegen und die Anschlußenden (36a-41a) der Anschlußfahnen (36-41) in der Mittelebene über den Vergußkörper vorstehen.

2. Modul nach Anspruch 1, dadurch gekennzeichnet, daß die Substratplatten (21) auf ihrer Außenfläche mit einem Metallüberzug (34) versehen sind.

3. Modul nach Anspruch 1 oder 2, dadurch gekennzeichnet, daß auf den Substratplatten (21) die Leiterbahnen (22-26) und die Anschlußfahnen (36-41) im wesentlichen spiegelbildlich ausgebildet und angeordnet sind.

## Claims

1. Module with semiconductor, circuit elements (27, 28, 29) in which two substrate plates (21) made of an electrically insulating material are arranged parallel and in spaced relationship, provided with conductor tracks (22 - 26) onto their corresponding surfaces (21a), the circuit-elements (27, 28, 29) of at least one of said substrate plates (21) being provided with a connecting area in a electrically contacting manner, and leads (36 - 41) being further connected to said conductor tracks (22 - 26), which project behind opposed end regions of the substrate plate (21), the leads (36 - 41) being provided with their respective outwardly placed connecting ends (36a - 41a) at the medial plane between the substrate plates (21) and in which the modul is encapsulated with an injection moulding compound in such a way that the outer regions (21b) of said substrate plates (21) are free and that the connecting ends (36a - 41a) of said leads (36 - 41) project behind the casted body along said medial plane.

2. Module according to claim 1, characterized in that said substrate plates (21) are provided onto their outer surfaces with a metallic cover (34).

3. Module according to claim 1 or 2, characterized in that the conductor tracks (22 - 26) and the leads (36 - 41) are provided and arranged onto said substrate plates (21) in an almost mirror-inverted way.

## Revendications

1. Module comportant des éléments de commutation de puissance à semi-conducteur (27,28,29), dans lequel deux plaques de substrat (21) en un matériau isolant de l'électricité sont disposées parallèlement et à distance l'une de l'autre et pourvues, sur leurs surfaces (21a), tournées l'une vers l'autre, de pistes conductrices (22 à 26), sur lesquelles, au moins pour l'une des plaques de substrat (21), les éléments de commutation à semi-conducteur (27,28,29) sont fixés, en assurant un contact électrique avec une surface de raccordement, dans lequel, en outre, les pistes conductrices (22 à 26) sont reliées à des queues de raccordement (36 à 41), qui dépassent au moins sur deux bords opposés de la plaque de substrat (21), dans lequel les queues de raccordement (36 à 41) sont situées, avec leurs extrémités de raccordement extérieures (36a à 41a), dans le plan médian entre les plaques de substrat et dans lequel le module est coulé, avec une masse moulée par injection, de telle façon que les surfaces extérieures (21b) des plaques de substrat (21) soient libres et que les extrémités de raccordement (36a à 41a) des queues de raccordement (36 à 41) fassent saillie au-dessus du corps moulé, dans le plan médian.

2. Module selon la revendication 1, caractérisé en ce que les plaques de substrat (21) sont pourvues sur leur surface extérieure d'un revêtement métallique (34).

3. Module selon la revendication 1 ou 2, caractérisé en ce que, sur les plaques de substrat (21), les pistes conductrices (22 à 26) et les queues de raccordement (36 à 41) sont réalisées et disposées de façon pratiquement symétrique par rapport à un plan.

## FIG. 1

## FIG. 2

## FIG. 3

43d   43   44

43a   36b   22   21   30   25   41b   41a   43c

36a   36   27   41

36d   41d

26   40b   40d

37a   37b   29

37d   40a

4   37   32   33   24   40   4

38d   39d

38a   38   38b   28   31   23   39b   39a   39

44   43b   44

## FIG. 4

43a   36d   36a   36b   32   40b   40   40a   40d

36   29   43c

26   21a

22   21b   24   21

## FIG. 5

43a   36d   36a   36b   32   24   40b   40a   40d

36   29   40   43c

26   21a

21b   22   34a   34   21

FIG. 6

FIG. 7

FIG. 8

FIG. 9

FIG. 10

FIG. 11